# EUROPEAN PATENT APPLICATION

(11) **EP 4 400 864 A1**
(43) Date of publication of application: **17.07.2024**
(21) Application number: 24151683.0
(22) Date of filing: 12.01.2024
(51) Int. Cl.: G01S 7/481, G01S 17/89

(54) **STACKED TIME-OF-FLIGHT MODULE**

(30) Priority: 13.01.2023 US 202363438946 P; 26.01.2023 US 202363441332 P; 21.12.2023 US 202318391655
(71) Applicant: Meta Platforms Technologies, LLC, Menlo Park, CA 94025 (US)
(72) Inventor: Mumbo, Jack, Menlo Park, 94025 (US); Cohoon, Gregory, Menlo Park, 94025 (US); Venkataraman, Harish, Menlo Park, 94025 (US); Nyaribo, Jeremiah, Menlo Park, 94025 (US); Gandhi, Jaspreet, Menlo Park, 94025 (US); Gualdino, Alexandra, Menlo Park, 94025 (US); Pendse, Rajendra, Menlo Park, 94025 (US)
(74) Representative: Murgitroyd & Company

(57) **Abstract**

A time-of-flight, ToF, module (200) includes a light source (230), a driver module (220), and a light sensor (240). The driver module (200) includes electrical circuitry to selectively drive the light source (230) to emit pulsed illumination light (231). The light sensor (240) is to sense returning light (235) reflected from a target (290). At least one of the light source (240), driver module (220), and light sensor (240) is stacked on another to reduce a footprint of the ToF module. ToF module (200) includes a substrate (210) including electrical traces (213). Substrate (210) may include a PCB or flex circuit which may be a multi-layered board having electrical traces routed on different layers. The multi-layered board may include ground planes, power planes, and vias to assist with routing electrical traces on and through the different layers. Light sensor (240) has a photosensitive region (243) and a non-photosensitive region (241) between which driver module (220) is disposed. Light sensor (240) is die-attached (211) to substrate (210) and driver module (220) is die-attached (221) to light sensor (240). Light sensor (240) may receive signals from electrical traces (213) by wire bonds (217) coupled between substrate (210) and light sensor (240). Driver module (220) may receive signals from electrical traces (213) by wire bonds (219). Interconnect pillars (229) are disposed between light source (230) and driver module (220). Embodiments may be implemented in conjunction with an artificial reality system of a head mounted display, HMD.

## Description

### CROSS-REFERENCE TO RELATED APPLICATIONS

This application claims priority to both U.S. provisional Application No. 63/441,332 filed January 26, 2023 and U.S. provisional Application No. 63/438,946 filed January 13, 2023.

### TECHNICAL FIELD

This disclosure relates generally to optics, and in particular to Time-of-Flight.

### BACKGROUND INFORMATION

Time-of-Flight (ToF) measurements are sensed by transmitting a signal (e.g. light) toward a target. A portion of the signal reflects or scatters from the target as a return signal and is sensed by a sensor. For direct Time-of-Flight (dToF) applications, the time between the transmission of the signal and the sensing of the return signal is measured to determine the distance between a ToF device and the target. For indirect Time-of-Flight (iToF) applications, the phase-shift of the returning light is used to determine the distance between a ToF device and the target. The velocity of the target can also be determined from multiple ToF measurements.

### SUMMARY

According to an aspect of the present invention there is provided a time-of-flight (ToF) module comprising: a light source configured to emit pulsed illumination light; a driver module including electrical circuitry configured to selectively drive the light source to emit the pulsed illumination light; a light sensor configured to sense returning light, wherein the returning light is the pulsed illumination light reflecting or scattering from a target; and a substrate to provide electrical traces for controlling the driver module and the light sensor, wherein the driver module or the light sensor is disposed between the light source and the substrate to reduce a footprint of the ToF module

Optionally, the light sensor includes a photosensitive region and a non-photosensitive region, and wherein the driver module is disposed between the light source and the non-photosensitive region of the light sensor.

Optionally, the driver module is disposed between the light sensor and the substrate, and wherein the driver module is disposed between the light source and the substrate.

Optionally, wirebonding electrically couples the electrical traces of the substrate to the light sensor.

Optionally, the driver module is bonded to the substrate in a die-attach process.

Optionally, the driver module is a Fan Out Wafer Level Chip-scale package (FOWLCSP) that is surface-mounted to the substrate, and wherein a ball grid array (BGA) of the FOWLCSP electrically couples the electrical traces of the substrate to the driver module.

Optionally, the light sensor is a chip-scale package (CSP) electrically connected to driver module with micro solder bumps or interconnect pillars.

Optionally, the light sensor is bonded to the driver module in a die-attach process.

Optionally, the substrate includes a cavity to house the driver module, wherein the driver module is disposed between the light source and the substrate and the driver module is also disposed between the light sensor and the substrate.

Optionally, the ToF module further comprises: mold compound disposed in the cavity of the substrate, wherein the mold compound is disposed between the driver module and the substrate and between the light sensor and the substrate; one or more through mold vias (TMVs) traversing through the mold compound between the substrate and the light sensor; a redistribution layer (RDL) electrically coupled to the one or more TSVs, the RDL disposed between the light sensor and the mold compound; and one or more wire bonds electrically coupling the light sensor to the RDL, wherein the one or more TMVs and the RDL combines to electrically couple the light sensor to the electrical traces of the substrate.

Optionally, the light sensor includes an array of single-photon avalanche diodes (SPADs).

Optionally, the light sensor is sensitive to infrared light and rejects visible light.

Optionally, the light source includes an array of illuminators to generate the pulsed illumination light.

Optionally, the illuminators in the array of illuminators include vertical-cavity surface-emitting lasers.

According to a further aspect of the present invention there is provided a fabrication process for fabricating a time-of-flight (ToF) module, the fabrication process comprising: disposing a light sensor on tape; disposing a backside mold compound over the tape and alongside the light sensor; forming frontside through mold vias (TMVs) traversing through the mold compound to the tape; forming backside redistribution layers (RDLs) that are electrically coupled to the frontside TMVs; removing the tape from the light sensor; forming a frontside RDL on a frontside of the light sensor that is opposite a backside of the light sensor, the frontside TMVs electrically coupling the frontside RDL and backside RDLs; and coupling a driver module to a non-photosensitive region of the light sensor, wherein the driver module is coupled between a light source and the non-photosensitive region of the light sensor.

Optionally, the fabrication process further comprises: wirebonding the driver module to the frontside RDL.

Optionally, the fabrication process further comprises: forming dams around a photosensitive region of the light sensor; and disposing a frontside mold compound to house the light sensor and the driver module while the dams exclude the frontside mold compound from the photosensitive region of the light sensor.

Optionally, the fabrication process further comprises: electrically coupling electrical components to the backside RDLs; disposing a middle mold compound layer over the electrical components; and forming backside TMVs through the middle mold compound layer to electrically connect the backside TMVs to the backside RDLs.

Optionally, the fabrication process further comprises: utilizing a hot bar to electrically couple a flex circuit with the backside TMVs.

According to a further aspect of the present invention there is provided a time-of-flight (ToF) module comprising: a light source configured to emit pulsed illumination light; a driver module including electrical circuitry configured to selectively drive the light source to emit the pulsed illumination light; a light sensor configured to sense returning light, wherein the returning light is the pulsed illumination light reflecting or scattering from a target, wherein the driver module is disposed between the light source and a non-photosensitive region of the light sensor; frontside redistribution layers (RDLs) disposed on a frontside of the light sensor that is opposite a backside of the light sensor; backside RDLs disposed on the backside of the light sensor; and frontside TMVs electrically coupling the frontside RDLs and the backside RDLs.

### BRIEF DESCRIPTION OF THE DRAWINGS

Non-limiting and non-exhaustive embodiments of the invention are described with reference to the following figures, wherein like reference numerals refer to like parts throughout the various views unless otherwise specified.
FIG. 1A illustrates a ToF module having a substrate, a sensor, and a light source driver for driving a light source;
FIG. 1B illustrates a plan view of the ToF module of FIG. 1A that includes a light source driver, a light source, and a sensor disposed on substrate;
FIG. 2 illustrates a ToF module having a driver module disposed between a light sensor and a light source, in accordance with aspects of the disclosure;
FIG. 3 illustrates a ToF module having a driver module disposed between a light sensor and a substrate, in accordance with aspects of the disclosure;
FIG. 4 illustrates a ToF module having a driver module disposed between a light sensor and a substrate, in accordance with aspects of the disclosure;
FIG. 5 illustrates a ToF module having a driver module disposed between a light sensor and a substrate, in accordance with aspects of the disclosure;
FIGs. 6A-6C illustrate a cavity in a substrate that is included in a ToF module, in accordance with aspects of the disclosure;
FIGs. 7A-7N illustrate an example fabrication process for fabricating a ToF module, in accordance with aspects of the disclosure; and
FIG. 8 illustrates a head mounted display (HMD) that may include a ToF module, in accordance with aspects of the disclosure.

### DETAILED DESCRIPTION

Embodiments of a stacked Time-of-Flight module are described herein. In the following description, numerous specific details are set forth to provide a thorough understanding of the embodiments. One skilled in the relevant art will recognize, however, that the techniques described herein can be practiced without one or more of the specific details, or with other methods, components, materials, etc. In other instances, well-known structures, materials, or operations are not shown or described in detail to avoid obscuring certain aspects.

Reference throughout this specification to "one embodiment" or "an embodiment" means that a particular feature, structure, or characteristic described in connection with the embodiment is included in at least one embodiment of the present invention. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

In some implementations of the disclosure, the term "near-eye" may be defined as including an element that is configured to be placed within 50 mm of an eye of a user while a near-eye device is being utilized. Therefore, a "near-eye optical element" or a "near-eye system" would include one or more elements configured to be placed within 50 mm of the eye of the user.

In aspects of this disclosure, visible light may be defined as having a wavelength range of approximately 380 nm - 700 nm. Non-visible light may be defined as light having wavelengths that are outside the visible light range, such as ultraviolet light and infrared light. Infrared light having a wavelength range of approximately 700 nm - 1 mm includes near-infrared light. In aspects of this disclosure, near-infrared light may be defined as having a wavelength range of approximately 700 nm - 1.6 µm.

In aspects of this disclosure, the term "transparent" may be defined as having greater than 90% transmission of light. In some aspects, the term "transparent" may be defined as a material having greater than 90% transmission of visible light.

Existing ToF modules have a light source, a light source driver, and a sensor. These components are disposed on a substrate such as a printed circuit board (PCB) or a flex circuit board and thus are mounted in the same plane (e.g. side-by-side on the substrate). This mounting configuration results in a relatively large x-y footprint for the ToF module.

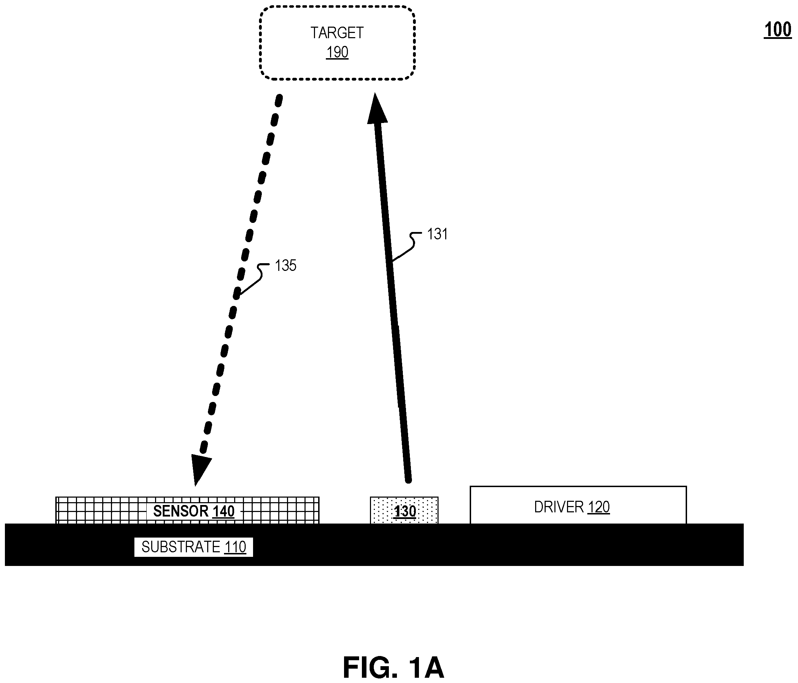

In some contexts, the x-y footprint of existing ToF modules is too large for engineering and/or aesthetic reasons. Head mounted devices are an example context that may benefit from ToF modules with a reduced footprint. A reduced footprint may assist in mounting the ToF module in a frame of the head mounted device, for example. In implementations of the disclosure, components of a ToF module are stacked to reduce the footprint of the ToF module. An example method of fabricating stacked ToF modules is also disclosed. These and other embodiments are described in more detail in connection with FIGs. 1A-8.

FIG. 1A illustrates an existing ToF module 100 having a substrate 110, a sensor 140, and a light source driver 120 for driving light source 130. The sensor 140, light source driver 120, and light source 130 are electrically coupled to substrate 110 and thus mounted on the same plane. In operation, light source driver 120 drives light source 130 to emit illumination light 131. The illumination light 131 is reflected and/or scattered from target 190 as returning light 135. Returning light 135 is measured by sensor 140 when it encounters sensor 140.

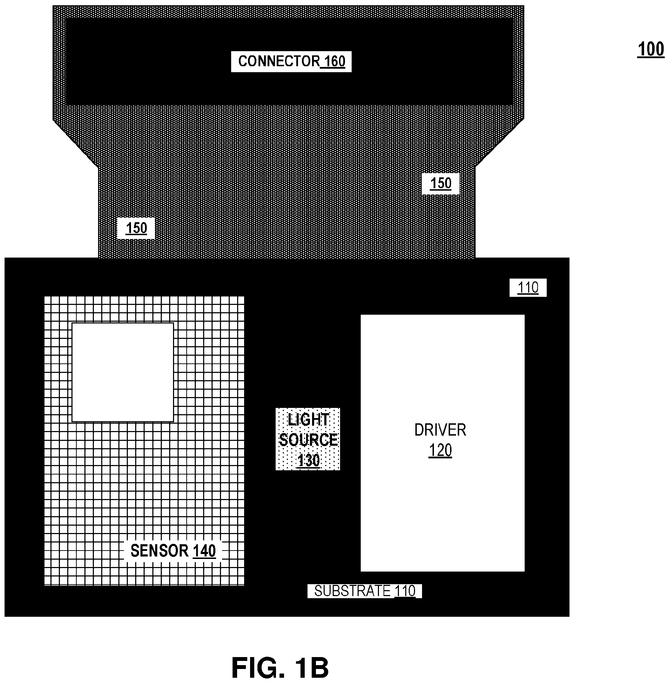

FIG. 1B illustrates a plan view of ToF module 100 that includes light source driver 120, light source 130, and sensor 140 disposed on substrate 110. Substrate 110 may be a PCB, for example. FIG. 1B also shows a connector 160 coupled to a flex circuit 150 that is coupled to substrate 110. Flex circuit 150 may provide signals between connector 160 and substrate 110.

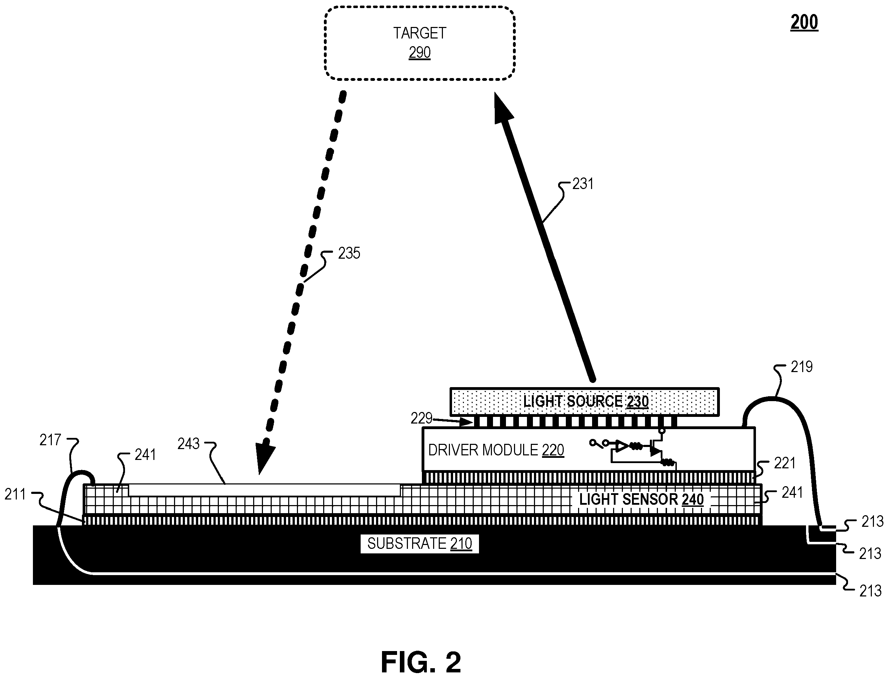

FIG. 2 illustrates a ToF module 200 having a driver module 220 disposed between light sensor 240 and light source 230, in accordance with aspects of the disclosure. ToF module 200 may be a direct ToF (dToF) module. ToF module 200 includes a substrate 210 including electrical traces 213. Substrate 210 may include a PCB or flex circuit, for example. The PCB or flex circuit may be a multi-layered board having electrical traces routed on different layers. The multi-layered board may include ground planes, power planes, and vias to assist with routing electrical traces on and through the different layers.

ToF module 200 also includes a light sensor 240 having a photosensitive region 243 and a non-photosensitive region 241. Light sensor 240 may include an image sensor. The image sensor may be a complementary metal-oxide-semiconductor (CMOS) image sensor. The photosensitive region 243 may include an array of light sensors (e.g. photodiodes) arranged in rows and columns. In an implementation, photosensitive region 243 includes an array of single-photon avalanche diodes (SPADs). The non-photosensitive region 241 may include readout circuitry and/or control circuitry to initiate and process images captured by photosensitive region 243. Light sensor 240 is configured to sense returning light 235. Returning light 235 is the pulsed illumination light 231 that is reflected or scattered from target 290 after being emitted by light source 230. Although not specifically illustrated, ToF module 200 may include a receiving lens or receiving lens assembly configured to focus returning light 235 to the photosensitive region 243 of light sensor 240.

Driver module 220 includes electrical circuitry configured to selectively drive light source 230 to emit pulsed illumination light 231. The electrical circuitry may include switches, transistors, and amplifiers, for example.

Light source 230 may include one or more illuminators to generate pulsed illumination light 231. Pulsed illumination light 231 may be infrared light. Pulsed illumination light 231 may be near-infrared light. Pulsed illumination light 231 may include a plurality of pulses where the pulse-widths are on the scale of nanoseconds. In an implementation, light source 230 includes an array of illuminators arranged in rows and columns. The illuminators may include lasers or LEDs. The illuminators may include vertical-cavity surface-emitting lasers (VCSELs). In an implementation, the pulsed illumination light 231 is narrow-band near-infrared light having a linewidth of less than 10 nm. Pulsed illumination light 231 may be centered around 850 nm or 940 nm, in some implementations. Pulsed illumination light 231 may be collimated light. Although not specifically illustrated, ToF module 200 may include a transmitting lens or transmitting lens assembly configured to focus the pulsed illumination light 231.

In the illustrated example of FIG. 2, driver module 220 is disposed between light source 230 and the non-photosensitive region 241 of light sensor 240. Light sensor 240 is shown as die-attached 211 to substrate 210 in FIG. 2 and driver module 220 is shown as die-attached 221 to light sensor 240. FIG. 2 shows that light sensor 240 may receive signals from electrical traces 213 by way of one or more wire bonds 217 coupled between substrate 210 and light sensor 240. FIG. 2 also shows driver module 220 may receive signals from electrical traces 213 by way of one or more wire bonds 219. In the illustrated implementation, interconnect pillars 229 are disposed between light source 230 and driver module 220. The interconnect pillars 229 carry the driving signals from driver module 220 to light source 230. Interconnect pillars 229 may be formed of copper, for example.

In operation, driver module 220 drives light source 230 to emit pulsed illumination light 231. A pulse in pulsed illumination light 231 is reflected and/or scattered from target 290 as returning light 235. Returning light 235 is measured by light sensor 240 when it encounters light sensor 240. When light sensor 240 includes an image sensor, each pixel in the image sensor will generate a ToF signal that can be used to determine a distance and/or velocity of target 290.

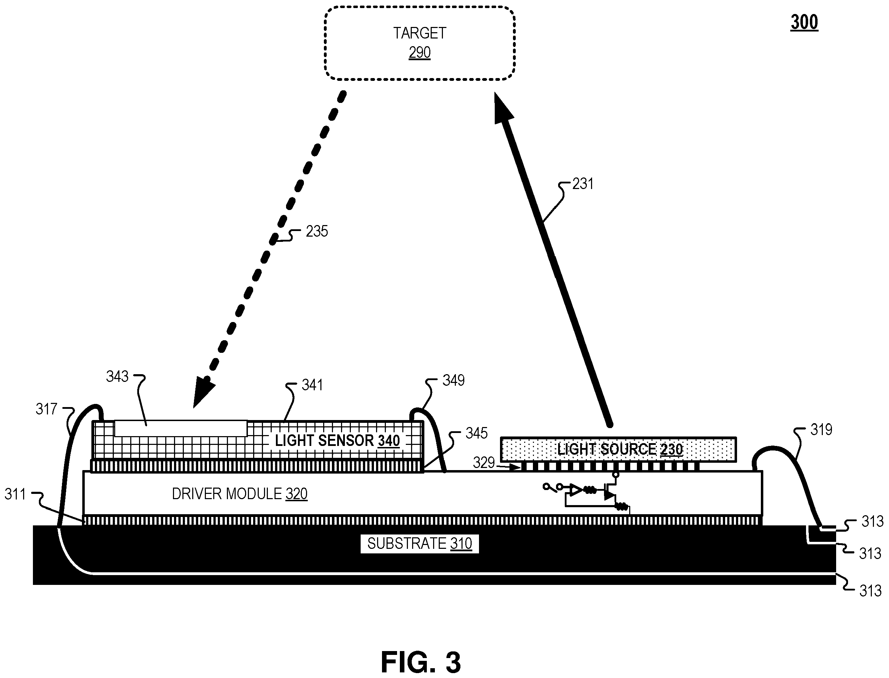

FIG. 3 illustrates a ToF module 300 having a driver module 320 disposed between light sensor 340 and substrate 310, in accordance with aspects of the disclosure. Driver module 320 is also disposed between light source 230 and substrate 310. ToF module 300 may be a direct ToF (dToF) module. ToF module 300 includes a substrate 310 including electrical traces 313. Substrate 310 may include a PCB or flex circuit, for example. The PCB or flex circuit may be a multi-layered board having electrical traces routed on different layers. The multi-layered board may include ground planes, power planes, and vias to assist with routing electrical traces on and through the different layers.

Light sensor 340 includes a photosensitive region 343 and a non-photosensitive region 341. Light sensor 340 may include an image sensor. The image sensor may be a complementary metal-oxide-semiconductor (CMOS) image sensor. The photosensitive region 343 may include an array of light sensors (e.g. photodiodes) arranged in rows and columns. In an implementation, photosensitive region 343 includes an array of single-photon avalanche diodes (SPADs). The non-photosensitive region 341 may include readout circuitry and/or control circuitry to initiate and process images captured by photosensitive region 343. Light sensor 340 is configured to sense returning light 235. Returning light 235 is the pulsed illumination light 231 that is reflected or scattered from target 290 after being emitted by light source 230. Although not specifically illustrated, ToF module 300 may include a receiving lens or receiving lens assembly configured to focus returning light 235 to the photosensitive region 343 of light sensor 340.

Driver module 320 includes electrical circuitry configured to selectively drive light source 230 to emit pulsed illumination light 231. The electrical circuitry may include switches, transistors, and amplifiers, for example. Although not specifically illustrated, ToF module 300 may include a transmitting lens or transmitting lens assembly configured to focus the pulsed illumination light 231.

In the illustrated example of FIG. 3, driver module 320 is disposed between light sensor 340 and substrate 310. Light sensor 340 is shown as die-attached 345 to driver module 320 in FIG. 3 and driver module 320 is shown as die-attached 311 to substrate 310. FIG. 3 shows that light sensor 340 may receive signals from electrical traces 313 by way of one or more wire bonds 317 coupled between substrate 310 and light sensor 340. FIG. 3 also shows driver module 320 may receive signals from electrical traces 313 by way of one or more wire bonds 319. Additionally, wire bond 349 may provide signals from driver module 320 to light sensor 340. In the illustrated implementation, interconnect pillars 329 are disposed between light source 230 and driver module 320. The interconnect pillars 329 carry the driving signals from driver module 320 to light source 230. Interconnect pillars 329 may be formed of copper, for example.

In operation, driver module 320 drives light source 230 to emit pulsed illumination light 231. A pulse in pulsed illumination light 231 is reflected and/or scattered from target 290 as returning light 235. Returning light 235 is measured by light sensor 340 when it encounters light sensor 340. When light sensor 340 includes an image sensor, each pixel in the image sensor will generate a ToF signal that can be used to determine a distance and/or velocity of target 290.

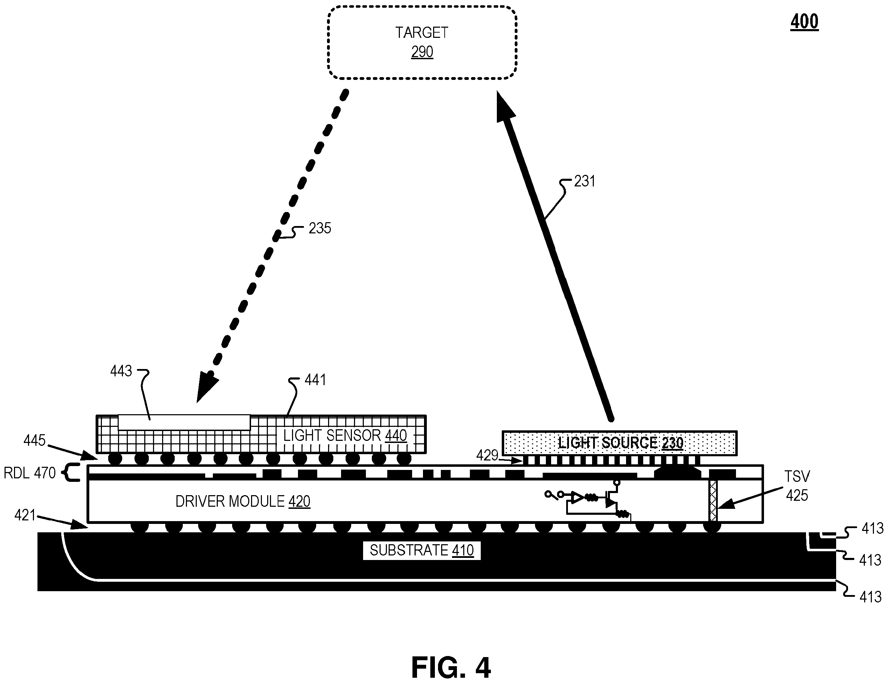

FIG. 4 illustrates a ToF module 400 having a driver module 420 disposed between light sensor 440 and substrate 410, in accordance with aspects of the disclosure. Driver module 420 is also disposed between light source 230 and substrate 410. ToF module 400 may be a direct ToF (dToF) module. ToF module 400 includes a substrate 410 including electrical traces 413. Substrate 410 may include a PCB or flex circuit, for example. The PCB or flex circuit may be a multi-layered board having electrical traces routed on different layers. The multi-layered board may include ground planes, power planes, and vias to assist with routing electrical traces on and through the different layers.

Light sensor 440 includes a photosensitive region 443 and a non-photosensitive region 441. Light sensor 440 may include an image sensor. The image sensor may be a complementary metal-oxide-semiconductor (CMOS) image sensor. The photosensitive region 443 may include an array of light sensors (e.g. photodiodes) arranged in rows and columns. In an implementation, photosensitive region 443 includes an array of single-photon avalanche diodes (SPADs). The non-photosensitive region 441 may include readout circuitry and/or control circuitry to initiate and process images captured by photosensitive region 443. Light sensor 440 is configured to sense returning light 235. Returning light 235 is the pulsed illumination light 231 that is reflected or scattered from target 290 after being emitted by light source 230. Although not specifically illustrated, ToF module 400 may include a receiving lens or receiving lens assembly configured to focus returning light 235 to the photosensitive region 443 of light sensor 440.

Driver module 420 includes electrical circuitry configured to selectively drive light source 230 to emit pulsed illumination light 231. The electrical circuitry may include switches, transistors, and amplifiers, for example. Although not specifically illustrated ToF module 400 may include a transmitting lens or transmitting lens assembly configured to focus the pulsed illumination light 231.

In the illustrated example of FIG. 4, driver module 420 is disposed between light sensor 440 and substrate 410. Driver module 420 is shown as a Fan Out Wafer Level Chip-Scale Package (FOWLCSP) that is surface-mounted to substrate 410 rather than die-attached. Hence, driver module 420 includes solder bumps (or a ball grid array) 421 for electrically connecting driver module 420 to electrical traces 413 of substrate 410. The FOWLCSP implementation of driver module 420 allows for one or more Through Silicon Vias (TSVs) 425 to carry electrical signals through driver module 420. The electrical signals transmitted through TSVs 425 may also be provided to light source 230. The electrical signals may be provided to light source 230 by way of redistribution layer (RDL) 470 and via interconnect pillars 429. Electrical signal transmitted through TSV may be provided to light sensor 440 via RDL 470 and micro solder bumps 445. In an implementation, light sensor 440 is a chip-scale package (CSP) electrically connected to driver module 420 with interconnect pillars.

In operation, driver module 420 drives light source 230 to emit pulsed illumination light 231. A pulse in pulsed illumination light 231 is reflected and/or scattered from target 290 as returning light 235. Returning light 235 is measured by light sensor 440 when it encounters light sensor 440. When light sensor 440 includes an image sensor, each pixel in the image sensor will generate a ToF signal that can be used to determine a distance and/or velocity of target 290.

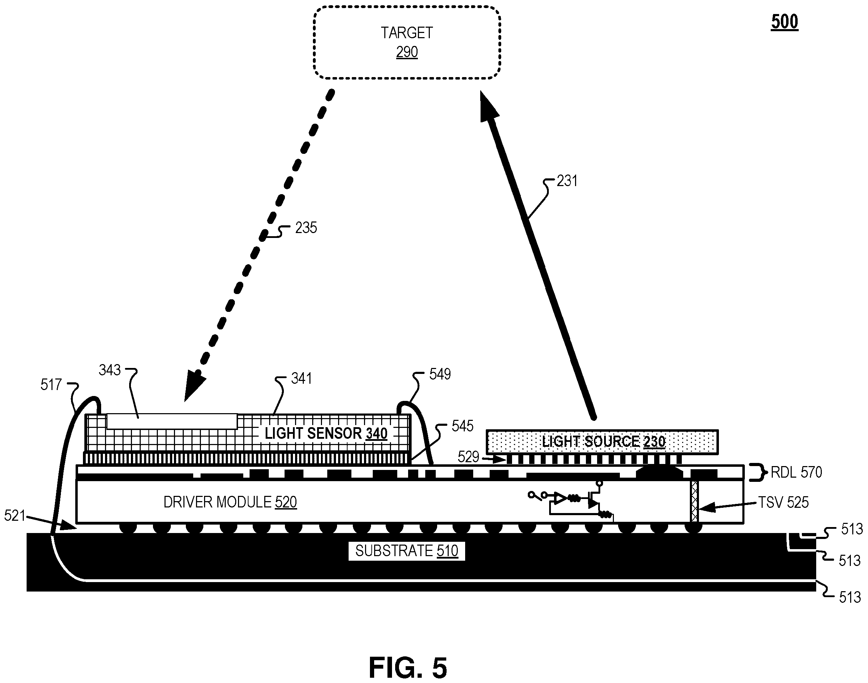

FIG. 5 illustrates a ToF module 500 having a driver module 520 disposed between light sensor 340 and substrate 510, in accordance with aspects of the disclosure. Driver module 520 is also disposed between light source 230 and substrate 510. ToF module 500 may be a direct ToF (dToF) module. ToF module 500 includes a substrate 510 including electrical traces 513. Substrate 510 may include a PCB or flex circuit, for example. The PCB or flex circuit may be a multi-layered board having electrical traces routed on different layers. The multi-layered board may include ground planes, power planes, and vias to assist with routing electrical traces on and through the different layers.

Light sensor 340 is configured to sense returning light 235. Returning light 235 is the pulsed illumination light 231 that is reflected or scattered from target 290 after being emitted by light source 230. Although not specifically illustrated, ToF module 500 may include a receiving lens or receiving lens assembly configured to focus returning light 235 to the photosensitive region 343 of light sensor 340.

Driver module 520 includes electrical circuitry configured to selectively drive light source 230 to emit pulsed illumination light 231. The electrical circuitry may include switches, transistors, and amplifiers, for example. Although not specifically illustrated ToF module 500 may include a transmitting lens or transmitting lens assembly configured to focus the pulsed illumination light 231.

In the illustrated example of FIG. 5, driver module 520 is disposed between light sensor 340 and substrate 510. Driver module 520 is shown as a Fan Out Wafer Level Chip-Scale Package (FOWLCSP) that is surface-mounted to substrate 510 rather than die-attached. Hence, driver module 520 includes solder bumps (or a ball grid array) 521 for electrically connecting driver module 520 to electrical traces 513 of substrate 510. The FOWLCSP implementation of driver module 520 allows for one or more Through Silicon Vias (TSVs) 525 to carry electrical signal through driver module 520. The electrical signals transmitted through TSVs 525 may be provided to light source 230 via RDL 570 and interconnect pillars 529. The electrical signals from TSVs 525 may be provided to light sensor 340 via RDL 570 and one or more wire bonds 549). FIG. 5 also illustrates that one or more wire bonds 517 may electrically couple light sensor 340 to electrical traces 513 of substrate 510. Light sensor 340 is shown as being die-attached 545 to driver module 520 in FIG. 5.

In operation, driver module 520 drives light source 230 to emit pulsed illumination light 231. A pulse in pulsed illumination light 231 is reflected and/or scattered from target 290 as returning light 235. Returning light 235 is measured by light sensor 340 when it encounters light sensor 340. When light sensor 340 includes an image sensor, each pixel in the image sensor will generate a ToF signal that can be used to determine a distance and/or velocity of target 290.

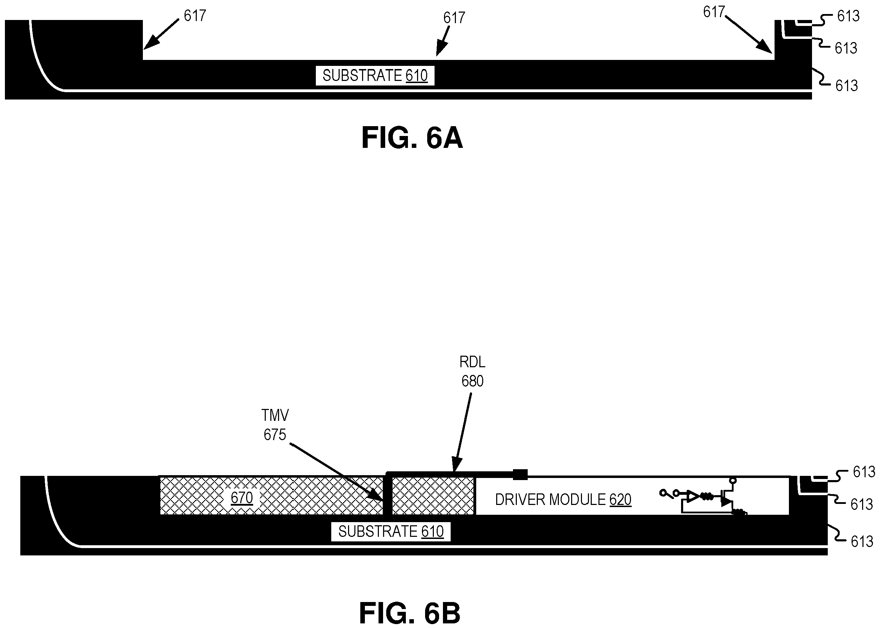

FIGs. 6A-6C illustrate a cavity 617 in a substrate 610 that is included in a ToF module 600, in accordance with aspects of the disclosure. FIG. 6A shows a substrate 610 including electrical traces 613. Substrate 610 may include a PCB or flex circuit, for example. The PCB or flex circuit may be a multi-layered board having electrical traces routed on different layers. The multi-layered board may include ground planes, power planes, and vias to assist with routing electrical traces on and through the different layers. Substrate 610 includes a cavity 617 to house components of a ToF module 600. Cavity 617 may be formed by removing layers of a multi-layer substrate, for example. Cavity 617 may also be formed in an additive process of selectively building the layers of substrate 610.

FIG. 6B illustrates driver module 620 housed in cavity 617. In an implementation, driver module 620 is flush with the top of cavity 617. Driver module 620 may sit on a bottom of cavity 617 and be electrically coupled to substrate 610 with micro solder bumps. Driver module 620 includes electrical circuitry configured to selectively drive light source 230 to emit pulsed illumination light 231. The electrical circuitry may include switches, transistors, and amplifiers, for example.

In an implementation, driver module 620 is a die included in a Fan Out Wafer Level Package (FOWLP) that includes a molding portion 670. In this implementation, one or more TMVs are included in molding portion 670 of the FOWLP and the TMVs are electrically coupled to electrical traces 613 in substrate 610. A Redistribution Layer (RDL) 680 may then be formed over the FOWLP where RDL 680 connects the RDL 680 to one or more TMVs 675.

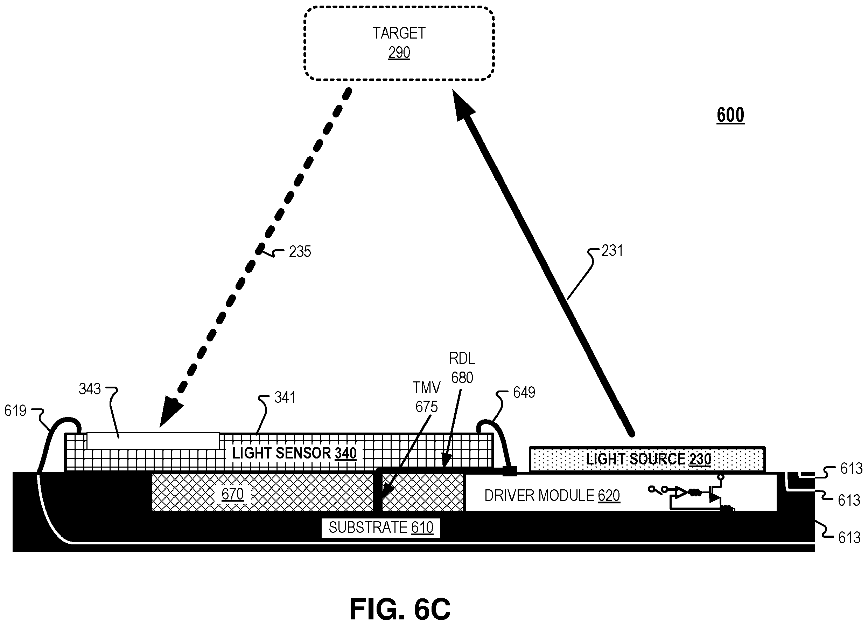

FIG. 6C illustrates a ToF module 600 including driver module 620 housed in the cavity of substrate 610. In FIG. 6C, driver module 620 is disposed between light source 230 and substrate 610. Driver module 620 is also disposed, at least partially, between light sensor 340 and substrate 610. Light source 230 may be electrically coupled to driver module 620 by way of interconnect pillars (not specifically illustrated) or micro solder bumps. Although not specifically illustrated, ToF module 600 may include a transmitting lens or transmitting lens assembly configured to focus the pulsed illumination light 231.

In an implementation, mold compound 670 is disposed in cavity 617 of the substrate 610 where the mold compound 670 is disposed between driver module 620 and substrate 610 and between light sensor 340 and substrate 610.

Light sensor 340 is disposed over at least a portion of RDL 680, in FIG. 6C. A portion of RDL 680 is disposed over driver module 620, in the illustrated implementation. Driver module 620 includes electrical circuitry configured to selectively drive light source 230 to emit pulsed illumination light 231. The electrical circuitry may include switches, transistors, and amplifiers, for example. Although not specifically illustrated, ToF module 600 may include a receiving lens or receiving lens assembly configured to focus returning light 235 to the photosensitive region 343 of light sensor 340.

One or more wire bonds 649 electrically couples light sensor 340 to RDL 680. The one or more TMVs 675 and RDL 680 combine to electrically couple the light sensor 340 to the electrical traces 613 of substrate 610. One or more wire bonds 619 may electrically couple electrical traces 613 with light sensor 340.

In operation, driver module 620 drives light source 230 to emit pulsed illumination light 231. A pulse in pulsed illumination light 231 is reflected and/or scattered from target 290 as returning light 235. Returning light 235 is measured by light sensor 340 when it encounters light sensor 340. When light sensor 340 includes an image sensor, each pixel in the image sensor will generate a ToF signal that can be used to determine a distance and/or velocity of target 290.

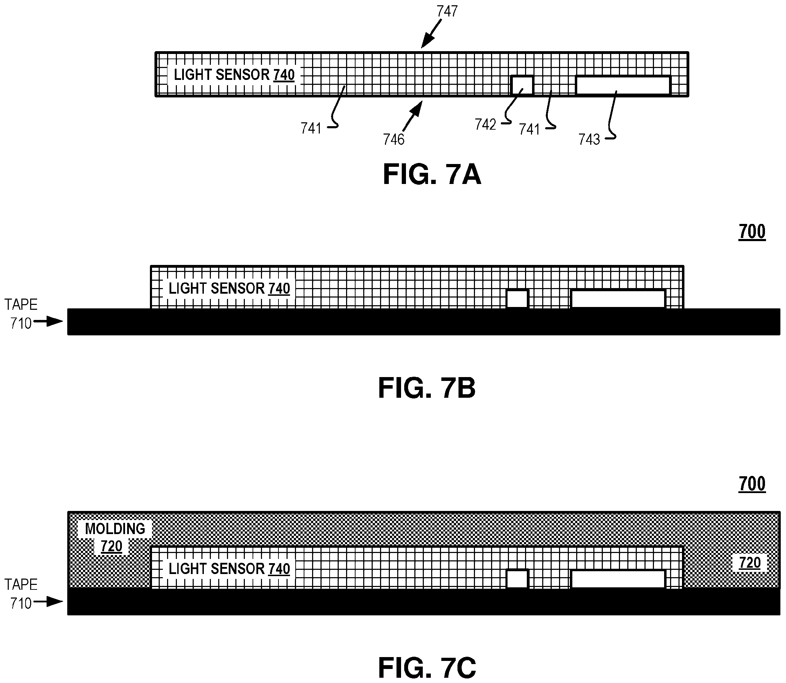

FIGs. 7A-7N illustrate an example fabrication process for fabricating a ToF module, in accordance with aspects of the disclosure. The fabrication process disclosed in FIG. 7A-7N may be considered a "Chip First Face Down" fabrication process.

FIG. 7A illustrates a light sensor 740 that includes a photosensitive region 743 and a non-photosensitive region 741. Light sensor 740 has a frontside 746 opposite a backside 747. Light sensor 740 also includes a reference photodiode 742. Light sensor 740 may include an image sensor. The image sensor may be a complementary metal-oxide-semiconductor (CMOS) image sensor. The photosensitive region 743 may include an array of light sensors (e.g. photodiodes) arranged in rows and columns. In an implementation, photosensitive region 743 includes an array of single-photon avalanche diodes (SPADs). The non-photosensitive region 741 may include readout circuitry and/or control circuitry to initiate and process images captured by photosensitive region 743.

In FIG. 7B, light sensor 740 is disposed face down on tape layer 710 to form structure 700.

In FIG. 7C, a backside mold compound 720 is disposed over tape layer 710 and alongside light sensor 740. Backside mold compound 720 may also cover a backside of light sensor 740, as illustrated.

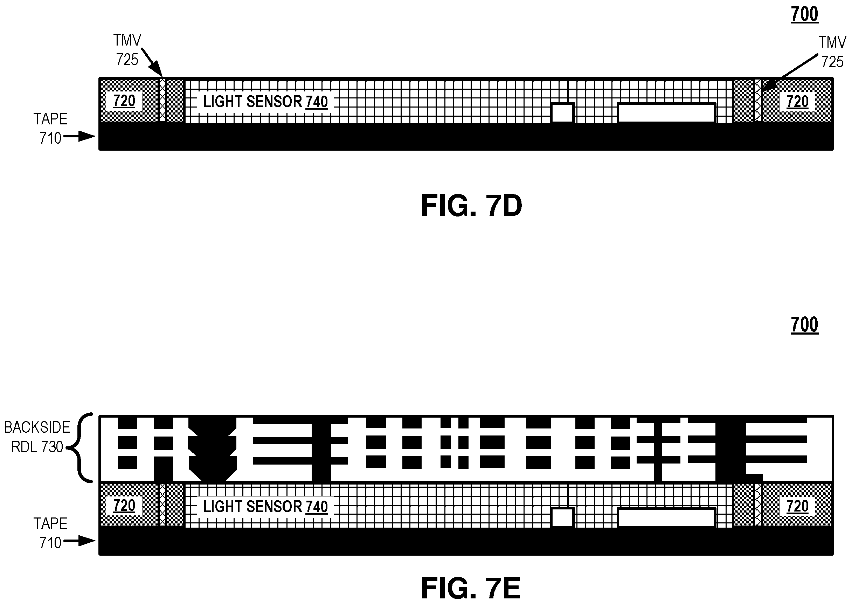

In FIG. 7D, frontside TMVs 725 are formed in backside molding compound 720. The frontside TMVs 725 may be formed by laser drilling followed by depositing a metal layer to form the frontside TMVs 725. TMVs may also be pre-plated and later encapsulated with backside mold compound 720 and the backside mold compound 720 can then be ground to expose the TMVs for connection purposes. A portion of backside mold compound 720 may have been removed from the backside of light sensor 740 to form structure 700, in FIG. 7D.

In FIG. 7E, backside redistribution layers (RDLs) 730 that are electrically coupled to the frontside TMVs 725 are formed on structure 700.

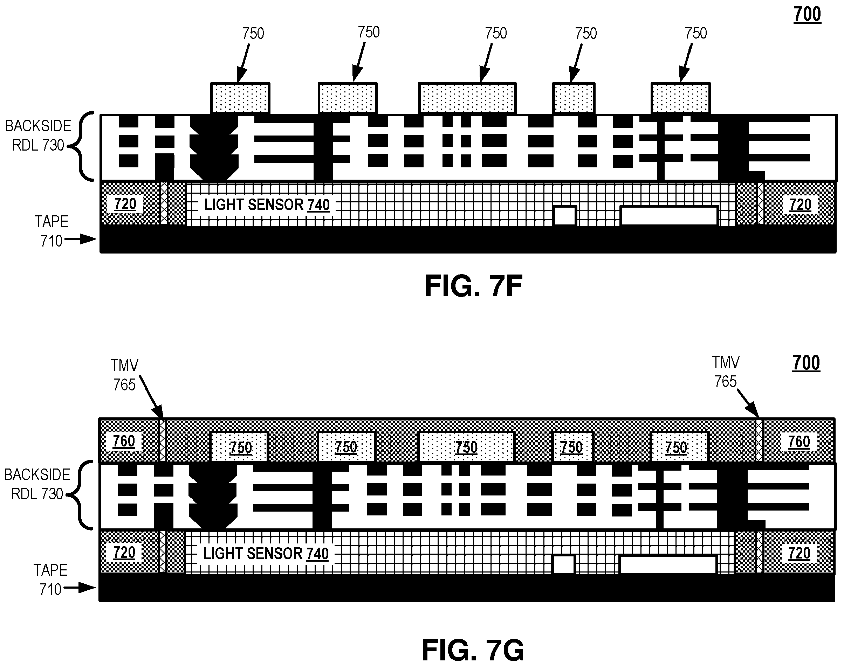

In FIG. 7F, electrical components 750 are electrically coupled to the backside RDLs 730. The electrical components 750 may be passive components such as resistors and/or capacitors. The electrical components may support light sensor 740 or a driver module, for example. The electrical components may be surface mount electrical components.

In FIG. 7G, a middle mold compound 760 is formed over electrical components 750 and backside TMVs 765 are formed through the middle mold compound 760 to electrically connect the backside TMVs 765 to the backside RDLs 730.

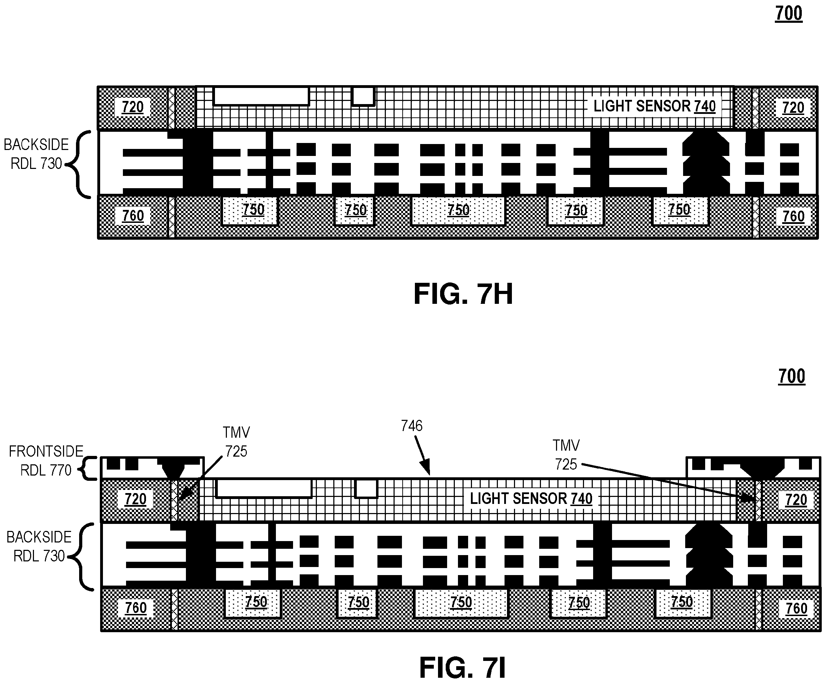

In FIG. 7H, tape layer 710 is removed and structure 700 is flipped.

In FIG. 7I, a frontside RDL 770 is formed on a frontside 746 of light sensor 740. Frontside TMVs 725 are electrically coupled to frontside RDL 770.

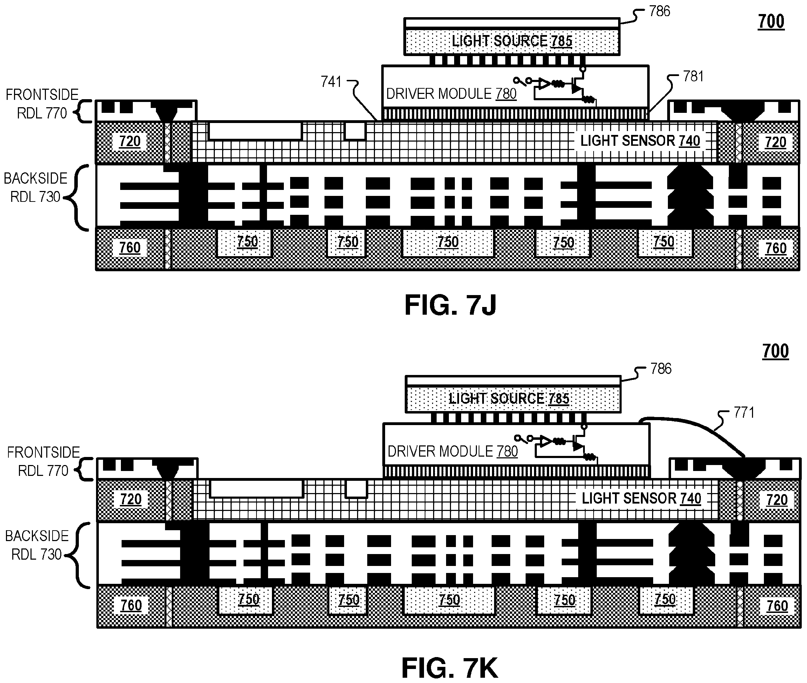

In FIG. 7J, driver module 780 is coupled to the non-photosensitive region 741 of light sensor 740. Driver module 780 is coupled between light source 785 and the non-photosensitive region 741 of light sensor 740. In FIG. 7J, driver module 780 is die-attached 781 to light sensor 740. Light source 785 may be electrically coupled to driver module 780 by interconnect pillars (illustrated) or micro solder bumps (not illustrated). Light source 785 may include a lens 786 disposed over light source 785 to focus pulsed illumination light emitted from light source 785. Lens 786 may also serve to protect light source 785 from external contaminants. Lens 786 may be formed of a refractive material.

Driver module 780 includes electrical circuitry configured to selectively drive light source 785 to emit pulsed illumination light. The electrical circuitry may include switches, transistors, and amplifiers, for example.

In FIG. 7K, frontside RDL 770 is wire-bonded to driver module 780 with one or more wire bonds 771.

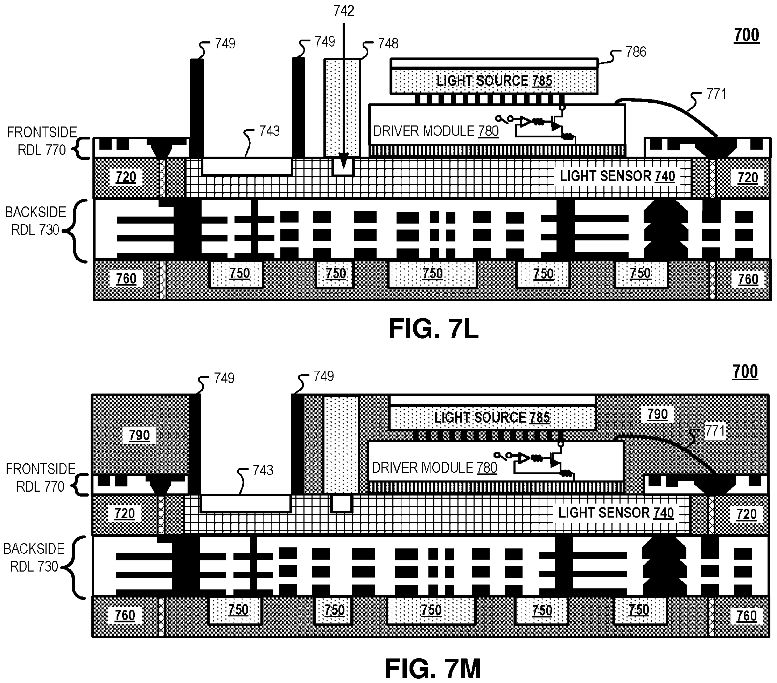

In FIG. 7L, dams 749 are formed around the photosensitive region 743 of light sensor 740 and a glass element 748 is attached above the reference photodiode 742 to cover the reference photodiode 742 from a future mold deposition.

In FIG. 7M, a frontside mold compound 790 is formed to house and protect light sensor 740 and driver module 780 while the dams 749 exclude the frontside mold compound 790 from the photosensitive region 743 of light sensor 740.

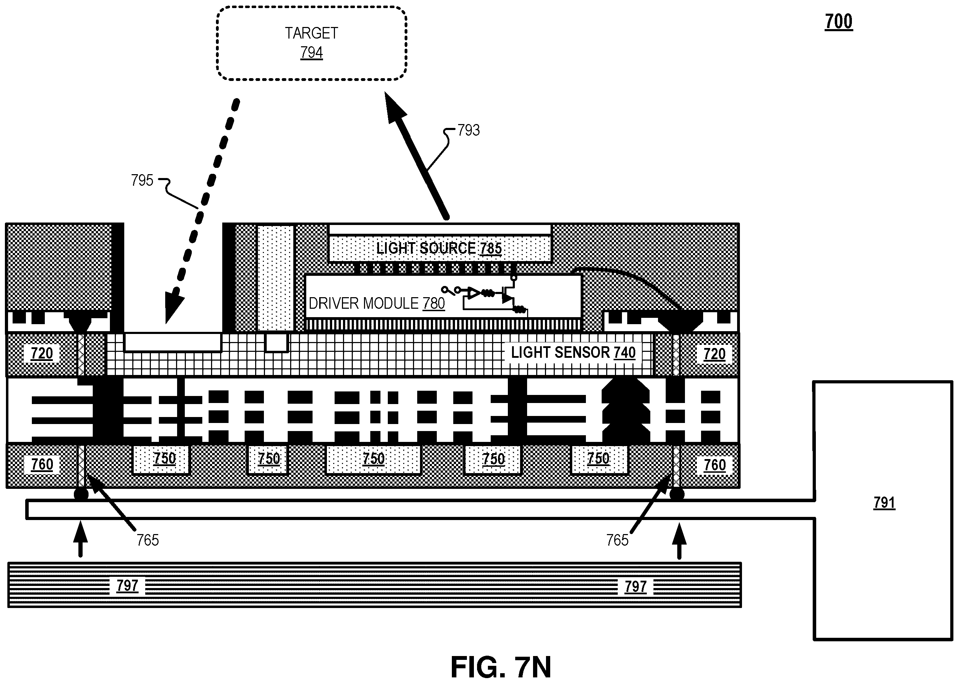

In FIG. 7N, a hot bar 797 is utilized to electrically coupled flex circuit 791 to backside TMVs 765 to form ToF module 700 from structure 700 of FIG. 7M. Hot Bar techniques include reflowing solder with the compression of hot bar 797 on flex circuit 791. In an implementation, An-isotropic Conductive Film (ACF) is used to electrically couple interconnects of a flex circuit to backside TMVs 765.

Light source 785 of ToF module 700 may include one or more illuminators to generate pulsed illumination light 793. Pulsed illumination light 793 may be infrared light. Pulsed illumination light 793 may be near-infrared light. Pulsed illumination light 793 may include a plurality of pulses where the pulse-widths are on the scale of nanoseconds. In an implementation, light source 785 includes an array of illuminators arranged in rows and columns. The illuminators may include lasers or LEDs. The illuminators may include vertical-cavity surface-emitting lasers (VCSELs). In an implementation, the pulsed illumination light 793 is narrow-band near-infrared light having a linewidth of less than 10 nm. Pulsed illumination light 793 may be centered around 850 nm or 940 nm, in some implementations. Pulsed illumination light 793 may be collimated light. Although not specifically illustrated, ToF module 700 may include a transmitting lens or transmitting lens assembly configured to focus the pulsed illumination light 793.

In operation, driver module 780 drives light source 785 to emit pulsed illumination light 793. A pulse in pulsed illumination light 793 is reflected and/or scattered from target 794 as returning light 795. Returning light 795 is measured by light sensor 740 when it encounters light sensor 740. When light sensor 740 includes an image sensor, each pixel in the image sensor will generate a ToF signal that can be used to determine a distance and/or velocity of target 794.

Among the benefits of fabricating a ToF module 700 using the process illustrated in FIGs. 7A-7M is the miniaturization of the electrical routing of ToF module 700 using RDLs generated by a foundry rather than relying on the much larger traces of printed circuit board fabricators. This advantage contributes to ToF module 700 being further miniaturized in the x-y footprint as well as the z-dimension due to thinner traces. In addition, the x-y footprint of ToF module 700 is further reduced from stacking light sensor 740, driver module 780, and light source 785 (when compared with arranging these three components on the same substrate plane).

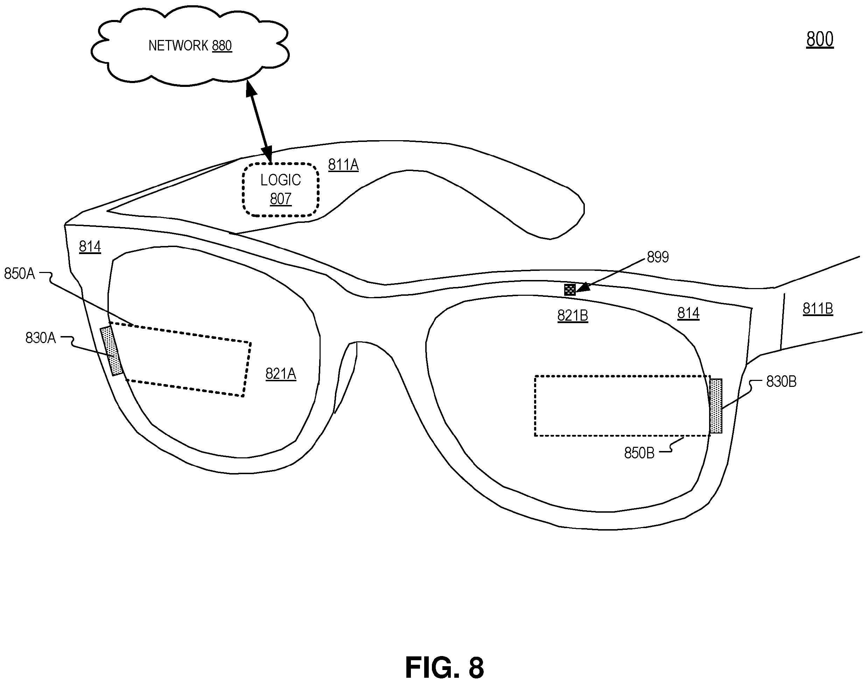

FIG. 8 illustrates a head mounted display (HMD) 800 that may include a ToF module 899, in accordance with aspects of the present disclosure. ToF module 899 may be utilized to image an eyebox region of a user of HMD 800 or to image an external environment of a user of HMD 800. ToF module 899 may be used to image hand gestures or facial expressions, in some implementations.

HMD 800 includes frame 814 coupled to arms 811A and 811B. Lens assemblies 821A and 821B are mounted to frame 814. Lens assemblies 821A and 821B may include a prescription lens matched to a particular user of HMD 800. The illustrated HMD 800 is configured to be worn on or about a head of a wearer of HMD 800.

In the HMD 800 illustrated in FIG. 8, each lens assembly 821A/821B includes a waveguide 850A/850B to direct image light generated by displays 830A/830B to an eyebox area for viewing by a user of HMD 800. Displays 830A/830B may include a beam-scanning display or a liquid crystal on silicon (LCOS) display for directing image light to a wearer of HMD 800 to present virtual images, for example.

Lens assemblies 821A and 821B may appear transparent to a user to facilitate augmented reality or mixed reality to enable a user to view scene light from the environment around them while also receiving image light directed to their eye(s) by, for example, waveguides 850. Lens assemblies 821A and 821B may include two or more optical layers for different functionalities such as display, eye-tracking, and optical power. In some embodiments, image light from display 830A or 830B is only directed into one eye of the wearer of HMD 800. In an embodiment, both displays 830A and 830B are used to direct image light into waveguides 850A and 850B, respectively. The implementations of the disclosure may also be used in head mounted devices (e.g. smartglasses) that don't necessarily include a display but are configured to be worn on or about a head of a wearer.

Frame 814 and arms 811 may include supporting hardware of HMD 800 such as processing logic 807, a wired and/or wireless data interface for sending and receiving data, graphic processors, and one or more memories for storing data and computer-executable instructions. Processing logic 807 may include circuitry, logic, instructions stored in a machine-readable storage medium, ASIC circuitry, FPGA circuity, and/or one or more processors. Processing logic 807 may be electrically connected to any of the ToF modules disclosed herein. In one embodiment, HMD 800 may be configured to receive wired power. In one embodiment, HMD 800 is configured to be powered by one or more batteries. In one embodiment, HMD 800 may be configured to receive wired data including video data via a wired communication channel. In one embodiment, HMD 800 is configured to receive wireless data including video data via a wireless communication channel. Processing logic 807 may be communicatively coupled to a network 880 to provide data to network 880 and/or access data within network 880. The communication channel between processing logic 807 and network 880 may be wired or wireless.

Embodiments of the invention may include or be implemented in conjunction with an artificial reality system. Artificial reality is a form of reality that has been adjusted in some manner before presentation to a user, which may include, e.g., a virtual reality (VR), an augmented reality (AR), a mixed reality (MR), a hybrid reality, or some combination and/or derivatives thereof. Artificial reality content may include completely generated content or generated content combined with captured (e.g., real-world) content. The artificial reality content may include video, audio, haptic feedback, or some combination thereof, and any of which may be presented in a single channel or in multiple channels (such as stereo video that produces a three-dimensional effect to the viewer). Additionally, in some embodiments, artificial reality may also be associated with applications, products, accessories, services, or some combination thereof, that are used to, e.g., create content in an artificial reality and/or are otherwise used in (e.g., perform activities in) an artificial reality. The artificial reality system that provides the artificial reality content may be implemented on various platforms, including a head-mounted display (HMD) connected to a host computer system, a standalone HMD, a mobile device or computing system, or any other hardware platform capable of providing artificial reality content to one or more viewers.

The term "processing logic" (e.g. processing logic 807) in this disclosure may include one or more processors, microprocessors, multi-core processors, Application-specific integrated circuits (ASIC), and/or Field Programmable Gate Arrays (FPGAs) to execute operations disclosed herein. In some embodiments, memories (not illustrated) are integrated into the processing logic to store instructions to execute operations and/or store data. Processing logic may also include analog or digital circuitry to perform the operations in accordance with embodiments of the disclosure.

A "memory" or "memories" described in this disclosure may include one or more volatile or non-volatile memory architectures. The "memory" or "memories" may be removable and non-removable media implemented in any method or technology for storage of information such as computer-readable instructions, data structures, program modules, or other data. Example memory technologies may include RAM, ROM, EEPROM, flash memory, CD-ROM, digital versatile disks (DVD), high-definition multimedia/data storage disks, or other optical storage, magnetic cassettes, magnetic tape, magnetic disk storage or other magnetic storage devices, or any other non-transmission medium that can be used to store information for access by a computing device.

Networks may include any network or network system such as, but not limited to, the following: a peer-to-peer network; a Local Area Network (LAN); a Wide Area Network (WAN); a public network, such as the Internet; a private network; a cellular network; a wireless network; a wired network; a wireless and wired combination network; and a satellite network.

Communication channels may include or be routed through one or more wired or wireless communication utilizing IEEE 802.11 protocols, short-range wireless protocols, SPI (Serial Peripheral Interface), I²C (Inter-Integrated Circuit), USB (Universal Serial Port), CAN (Controller Area Network), cellular data protocols (e.g. 3G, 4G, LTE, 5G), optical communication networks, Internet Service Providers (ISPs), a peer-to-peer network, a Local Area Network (LAN), a Wide Area Network (WAN), a public network (e.g. "the Internet"), a private network, a satellite network, or otherwise.

A computing device may include a desktop computer, a laptop computer, a tablet, a phablet, a smartphone, a feature phone, a server computer, or otherwise. A server computer may be located remotely in a data center or be stored locally.

The processes explained above are described in terms of computer software and hardware. The techniques described may constitute machine-executable instructions embodied within a tangible or non-transitory machine (e.g., computer) readable storage medium, that when executed by a machine will cause the machine to perform the operations described. Additionally, the processes may be embodied within hardware, such as an application specific integrated circuit ("ASIC") or otherwise.

A tangible non-transitory machine-readable storage medium includes any mechanism that provides (i.e., stores) information in a form accessible by a machine (e.g., a computer, network device, personal digital assistant, manufacturing tool, any device with a set of one or more processors, etc.). For example, a machine-readable storage medium includes recordable/non-recordable media (e.g., read only memory (ROM), random access memory (RAM), magnetic disk storage media, optical storage media, flash memory devices, etc.).

The above description of illustrated embodiments of the invention, including what is described in the Abstract, is not intended to be exhaustive or to limit the invention to the precise forms disclosed. While specific embodiments of, and examples for, the invention are described herein for illustrative purposes, various modifications are possible within the scope of the invention, as those skilled in the relevant art will recognize.

These modifications can be made to the invention in light of the above detailed description. The terms used in the following claims should not be construed to limit the invention to the specific embodiments disclosed in the specification. Rather, the scope of the invention is to be determined entirely by the following claims, which are to be construed in accordance with established doctrines of claim interpretation.

## Claims

1. A time-of-flight (ToF) module comprising:
a light source configured to emit pulsed illumination light;
a driver module including electrical circuitry configured to selectively drive the light source to emit the pulsed illumination light;
a light sensor configured to sense returning light, wherein the returning light is the pulsed illumination light reflecting or scattering from a target; and
a substrate to provide electrical traces for controlling the driver module and the light sensor, wherein the driver module or the light sensor is disposed between the light source and the substrate to reduce a footprint of the ToF module.

2. The ToF module of claim 1, wherein the light sensor includes a photosensitive region and a non-photosensitive region, and wherein the driver module is disposed between the light source and the non-photosensitive region of the light sensor.

3. The ToF module of claim 1 or 2, wherein the driver module is disposed between the light sensor and the substrate, and wherein the driver module is disposed between the light source and the substrate.

4. The ToF module of claim 3, wherein wirebonding electrically couples the electrical traces of the substrate to the light sensor.

5. The ToF module of claim 3 or 4, wherein the driver module is bonded to the substrate in a die-attach process.

6. The ToF module of claim 3, 4 or 5, wherein the driver module is a Fan Out Wafer Level Chip-scale package (FOWLCSP) that is surface-mounted to the substrate, and wherein a ball grid array (BGA) of the FOWLCSP electrically couples the electrical traces of the substrate to the driver module.

7. The ToF module of claim 6, wherein the light sensor is a chip-scale package (CSP) electrically connected to driver module with micro solder bumps or interconnect pillars.

8. The ToF module of claim 3, wherein the light sensor is bonded to the driver module in a die-attach process.

9. The ToF module of any preceding claim, wherein the substrate includes a cavity to house the driver module, wherein the driver module is disposed between the light source and the substrate and the driver module is also disposed between the light sensor and the substrate.

10. The ToF module of claim 9 further comprising:
mold compound disposed in the cavity of the substrate, wherein the mold compound is disposed between the driver module and the substrate and between the light sensor and the substrate;
one or more through mold vias (TMVs) traversing through the mold compound between the substrate and the light sensor;
a redistribution layer (RDL) electrically coupled to the one or more TSVs, the RDL disposed between the light sensor and the mold compound; and
one or more wire bonds electrically coupling the light sensor to the RDL, wherein the one or more TMVs and the RDL combines to electrically couple the light sensor to the electrical traces of the substrate.

11. The ToF module of any preceding claim, and any one or more of:
a) wherein the light sensor includes an array of single-photon avalanche diodes (SPADs); or
b) wherein the light sensor is sensitive to infrared light and rejects visible light.

12. The ToF module of any preceding claim, wherein the light source includes an array of illuminators to generate the pulsed illumination light, in which case optionally wherein the illuminators in the array of illuminators include vertical-cavity surface-emitting lasers.

13. A fabrication process for fabricating a time-of-flight (ToF) module, the fabrication process comprising:
disposing a light sensor on tape;
disposing a backside mold compound over the tape and alongside the light sensor;
forming frontside through mold vias (TMVs) traversing through the mold compound to the tape;
forming backside redistribution layers (RDLs) that are electrically coupled to the frontside TMVs;
removing the tape from the light sensor;
forming a frontside RDL on a frontside of the light sensor that is opposite a backside of the light sensor, the frontside TMVs electrically coupling the frontside RDL and backside RDLs; and
coupling a driver module to a non-photosensitive region of the light sensor, wherein the driver module is coupled between a light source and the non-photosensitive region of the light sensor.

14. The fabrication process of claim 13, and any one or more of:
a) further comprising: wirebonding the driver module to the frontside RDL; or .
b) further comprising: forming dams around a photosensitive region of the light sensor; and disposing a frontside mold compound to house the light sensor and the driver module while the dams exclude the frontside mold compound from the photosensitive region of the light sensor; or
c) further comprising:electrically coupling electrical components to the backside RDLs;
disposing a middle mold compound layer over the electrical components; and
forming backside TMVs through the middle mold compound layer to electrically connect the backside TMVs to the backside RDLs, in which case optionally further comprising: utilizing a hot bar to electrically couple a flex circuit with the backside TMVs.

15. A time-of-flight (ToF) module comprising:
a light source configured to emit pulsed illumination light;
a driver module including electrical circuitry configured to selectively drive the light source to emit the pulsed illumination light;
a light sensor configured to sense returning light, wherein the returning light is the pulsed illumination light reflecting or scattering from a target, wherein the driver module is disposed between the light source and a non-photosensitive region of the light sensor;
frontside redistribution layers (RDLs) disposed on a frontside of the light sensor that is opposite a backside of the light sensor;
backside RDLs disposed on the backside of the light sensor; and
frontside TMVs electrically coupling the frontside RDLs and the backside RDLs.
